# EUROPEAN PATENT APPLICATION

(11) **EP 4 773 783 A1**
(43) Date of publication of application: **08.07.2026**
(21) Application number: 24858739.6
(22) Date of filing: 30.08.2024
(51) Int. Cl.: H10K 71/12, H10K 85/10, H10K 71/20, H10K 50/11, H10K 50/80

(54) **DISPLAY PANEL AND PREPARATION METHOD THEREFOR**

(30) Priority: 31.08.2023 CN 202311113232
(71) Applicant: HKC Corporation Limited, Shenzhen, Guangdong 518101 (CN)
(72) Inventor: FENG, Yajuan, Shenzhen, Guangdong 518101 (CN); YI, Wenyu, Shenzhen, Guangdong 518101 (CN); WEI, Dongmei, Shenzhen, Guangdong 518101 (CN); CHEN, Jie, Shenzhen, Guangdong 518101 (CN); CAO, Zhonglin, Shenzhen, Guangdong 518101 (CN); WU, Chuan, Shenzhen, Guangdong 518101 (CN); YE, Lidan, Shenzhen, Guangdong 518101 (CN)
(74) Representative: De Arpe Tejero, Manuel
(86) International application number: PCT/CN2024/115909
(87) International publication number: WO 2025/045209

(57) **Abstract**

A method of manufacturing a display panel, including: providing an array substrate; preparing a light emitting layer on the array substrate; preparing a second electrode pattern layer on the light emitting layer. The preparing a light emitting layer on the array substrate, includes: coating an active group material on the first electrode pattern layer to form a bonding layer; placing the array substrate in a reaction solution containing a light emitting material to enable the light emitting material to attach to the bonding layer to form the light emitting layer. The active group material has a first functional group, the light emitting material has a second functional group and a third functional group. The second functional group and the first functional group can undergo a grafting copolymerization reaction. The third functional groups of molecules of the light emitting material can undergo a polymerization reaction.

## Description

### CROSS REFERENCE TO RELATED APPLICATIONS

The present application claims the priority of the Chinese patent application No. 202311113232.3, filed on August 31, 2023, contents of which are incorporated herein by its entireties.

### TECHNICAL FIELD

Embodiments of the present disclosure relate to the technical field of displaying, and more specifically, to a display panel and a method of manufacturing a display panel.

### BACKGROUND

An organic light emitting diode (OLED) display panel, compared to a liquid crystal display (LCD) panel, is fully solid, actively emits light, has high brightness and high contrast, is ultra-thin, has lower power consumption and no viewing angle limitation, and can operate at a wide range of operating temperatures. Therefore, the OLED display panel has attracted increasing attention in the art.

In a process of manufacturing an OLED device, a critical and costly process is deposition of light emitting materials. In the art, a vacuum evaporation deposition machine and a fine metal mask (FMM) may be used in combination to perform the deposition of light emitting materials. However, firstly, the vacuum evaporation machine is expensive and can be provided by limited suppliers, localized production cannot be achieved easily. Second, the FMM is a consumable core component. One FMM can only be applied to prepare one model of display products, mass production cannot be achieved, and high-end FMMs cannot be easily obtained commercially. Thirdly, in the above process, the light emitting materials, which are expensive, has a utilization rate of less than 20% and cannot be recycled easily, resulting in a large amount of material waste. Therefore, alternative processes for the deposition of the light emitting materials on a substrate needs to be developed, and a method of manufacturing the OLED display panel without using the FMM needs to be developed.

### SUMMARY

The present disclosure provides a display panel and a method of manufacturing the display panel, so as to solve the technical problem of highly accurate alignment, high manufacturing costs, and the low utilization rate of the light emitting materials during the evaporation.

In a first aspect, the present disclosure provides a method of manufacturing a display panel, including:
providing an array substrate, where the array substrate includes a substrate, a driver circuit layer formed on a side of the substrate, and a first electrode pattern layer formed on a side of the driver circuit layer away from the substrate; the first electrode pattern layer comprises a plurality of first electrodes arranged into an array;
preparing a light emitting layer on the array substrate;
preparing a second electrode pattern layer on the light emitting layer; where the second electrode pattern layer includes a plurality of second electrodes in one-to-one correspondence with the plurality of first electrodes.

The preparing a light emitting layer on the array substrate, includes:
coating an active group material on the first electrode pattern layer to form a bonding layer;
placing the array substrate in a reaction solution containing a light emitting material to enable the light emitting material to attach to the bonding layer to form the light emitting layer.

The active group material has a first functional group, the light emitting material has a second functional group and a third functional group; in a reaction stage, the second functional group and the first functional group undergo a grafting copolymerization reaction to enable the light emitting material to attach to the bonding layer; and third functional groups undergo a polymerization reaction to form the light emitting layer having a preset thickness.

In some embodiments, the placing the array substrate in a reaction solution containing a light emitting material to enable the light emitting material to attach to the bonding layer to form the light emitting layer, includes:
placing the array substrate in a first reaction solution containing the light emitting material, regulating a first reaction environment, to enable the light emitting material to the bonding layer;
placing the array substrate in a second reaction solution containing light emitting material, regulating a second reaction environment, to form the light emitting layer having the preset thickness.

In some embodiments, prior to the placing the array substrate in a reaction solution containing a light emitting material, the method further includes:
coating a photoresist on the bonding layer, performing exposure development to expose a portion of the bonding layer corresponding to the plurality of first electrodes.

After the placing the array substrate in a reaction solution containing a light emitting material to enable the light emitting material to attach to the bonding layer to form the light emitting layer, the method further includes:
removing a photoresist.

In some embodiments, the light emitting layer comprises a first light emitting layer, a second light emitting layer, and a third light emitting layer; the method further includes: repeating the operation of preparing the light emitting layer on the array substrate, so as to form the first light emitting layer, the second light emitting layer, and the third light emitting layer.

In some embodiments, during repeating the operation of preparing the light emitting layer on the array substrate, the coating the active group material on the first electrode pattern layer is performed only once; and an orthographic projection of the bonding layer on the first electrode pattern layer covers the first electrode pattern layer.

In some embodiments, the method further includes:
preparing an encapsulation layer on the second electrode pattern layer and filling the encapsulation layer in a gap between adjacent light emitting layers;
providing a color film substrate, wherein the color film substrate comprises at least a black matrix; and
attaching the color film substrate to the array substrate.

In a second aspect, the present disclosure provides a display panel, including:
a driver substrate, including: a substrate, a driver circuit layer formed on a side of the substrate, and a first electrode pattern layer formed on a side of the driver circuit layer away from the substrate; the first electrode pattern layer comprises a plurality of first electrodes arranged into an array;
a light emitting layer, arranged on a side of the first electrode pattern layer away from the substrate;
a second electrode pattern layer, arranged on a side of the light emitting layer away from the first electrode pattern layer, wherein the second electrode pattern layer comprises a plurality of second electrodes in one-to-one correspondence with the plurality of first electrodes.

The display panel further comprises a bonding layer, the bonding layer is disposed between the first electrode pattern layer and the light emitting layer; the bonding layer includes an active group material, the active group material has a first functional group; the light emitting layer comprises a light emitting material, the light emitting material has a second functional group and a third functional group; the first functional group is grafted with the second functional group, to enable the light emitting layer to be attached to the bonding layer; third functional groups undergo a polymerization reaction to enable the light emitting material to form the light emitting layer having a preset thickness.

In some embodiments, the light emitting material is an organic light emitting material and/or an inorganic light emitting material. The organic light emitting material has the second functional group and the third functional group. The inorganic light emitting material comprises an inorganic core and an organic shell layer wrapping around the inorganic core, the organic shell layer has the second functional group and the third functional group.

In some embodiments, the display panel further includes an encapsulation layer and a color film layer, the encapsulation layer is disposed on a side of the second electrode pattern layer away from the light emitting layer and fills a gap between adjacent light emitting layers, the color film layer is disposed on a side of the encapsulation layer away from the second electrode pattern layer.

In some embodiments, the light emitting layer comprises a first light emitting layer, a second light emitting layer, and a third light emitting layer; wherein the first light emitting layer, the second light emitting layer, and the third light emitting layer are in different colors from each other; the first light emitting layer, the second light emitting layer, and the third light emitting layer being arranged in a preset sequence; the display panel further comprises an encapsulation layer, the encapsulation layer is disposed on a side of the second electrode pattern layer away from the light emitting layer and fills a gap between adjacent light emitting layers.

According to the present disclosure, a display panel and a method of manufacturing the display panel are provided. In the method, an active group material is coated on a first electrode pattern layer of an array substrate to form a bonding layer. Further, a wet process is performed, the array substrate is placed in a reaction solution containing a light emitting material, such that the light emitting material is attached to the bonding layer to form a light emitting layer. The light emitting material can form a film, without using any expensive equipment, such as the vacuum evaporation deposition machine and the FMM. Therefore, manufacturing costs are effectively reduced, and competitiveness of products is improved. Specifically, the active group material has a first functional group, the light emitting material has a second functional group and a third functional group. After the array substrate is placed in the reaction solution, a polymerization reaction occurs between the light emitting material and the active group of the bonding layer. During reaction, the second functional group and the first functional group undergo a grafting copolymerization reaction, such that the light emitting material is attached to the bonding layer. Molecules of the light emitting material undergo polymerization, and the third functional group and the third functional group undergo polymerization. In this way, the molecules of the light emitting material undergo cohesion to form a film layer having a preset thickness, i.e., the light emitting layer is formed. Furthermore, according to the film formation based on the wet process, the utilization rate of the light emitting material is greatly increased, avoiding material wastes.

### BRIEF DESCRIPTION OF THE DRAWINGS

To more clearly illustrate technical solutions in the embodiments of the present disclosure or the related art, the accompanying drawings needed for describing the embodiments of the present disclosure or the related art will be briefly introduced in the following. Obviously, the drawings in the following description are only some embodiments of the present disclosure, and any ordinary skilled person in the art may obtain other drawings based on these drawings without creative work.
FIG. 1 is a flow chart of a method of manufacturing a display panel according to a first embodiment of the present disclosure.
FIG. 2 is a structural schematic view of a display panel according to the first embodiment of the present disclosure.
FIG. 3 is a flow chart of a method of preparing a light emitting layer according to an embodiment of the present disclosure.
FIG. 4 is a process of the method of preparing the light emitting layer according to an embodiment of the present disclosure.
FIG. 5 is a structural schematic view of a first state of an array substrate being placed in a reaction solution according to the first embodiment of the present disclosure.
FIG. 6 is a structural schematic view of a second state of the array substrate being placed in the reaction solution according to the first embodiment of the present disclosure.
FIG. 7 is a flow chart of an operation S22 according to an embodiment of the present disclosure.
FIG. 8 is a flow chart of a method of manufacturing the display panel according to a second embodiment of the present disclosure.
FIG. 9 is a flow chart of a method of manufacturing the display panel according to a third embodiment of the present disclosure.
FIG. 10 is a process of the method of preparing the light emitting layer shown in FIG. 9.
FIG. 11 is a structural schematic view of the display panel manufactured based on the method shown in FIG. 9.

### Reference numerals in the drawings:

100-display panel; 10-array substrate; 11-substrate; 12-driver circuit layer; 13-first electrode pattern layer; 131-first electrode; 20-light emitting unit; 21-bonding layer; 21a-first functional group; 22-light emitting layer; 221-first light emitting layer; 222-second light emitting layer; 223-third light emitting layer; 22a-inorganic core; 22s-organic shell layer; 22b-second functional group; 22c-third functional group; 23-second electrode pattern layer; 231-second electrode; 24-encapsulation layer; 251-first light emitting unit; 252-second light emitting unit; 253-third light emitting unit; 30-color film substrate; 31-black matrix; 311-pixel opening; 32-color film layer; 321-first color resist layer; 322-second color resist layer; 323-third color resist layer; 40-reaction solution; 41-first reaction solution; 42-second reaction solution; PR-photoresist; d-preset thickness.

### DETAILED DESCRIPTIONS

Technical solutions of the present disclosure will be described in detail by referring to the accompanying drawings.

In the following description, specific details such as particular system structures, interfaces, techniques, and the like are provided for the purpose of illustration and not for limitation, in order to provide a thorough understanding of the present disclosure.

The technical solutions in the embodiments of the present disclosure will be clearly and completely described below by referring to the accompanying drawings in the embodiments of the present disclosure. Apparently, the described embodiments are only a part of, not all of, the embodiments of the present disclosure. All other embodiments, which are obtained by any ordinary skilled person in the art based on the embodiments in the present disclosure without making creative work, shall fall within the scope of the present disclosure.

Terms "first", "second", and "third" in the present disclosure are used for descriptive purposes only and are not to indicate or imply relative importance or implicitly specifying the number of technical features. Therefore, a feature defined with "first", "second", "third" may include at least one such feature, either explicitly or implicitly. In the description of the present disclosure, "a plurality of" means at least two, such as two, three, and so on, unless otherwise expressly and specifically limited. All directional indications (such as up, down, left, right, front, rear ......) in the embodiments of the present disclosure are only used to explain a relative positional relationship and movement between components at a particular attitude (the attitude as shown in the accompanying drawings). The directional indication may be changed accordingly when the particular attitude is changed. Furthermore, terms "include" and "have" and any variations thereof are intended to cover non-exclusive inclusion. For example, a process, a method, a system, a product or an apparatus including a series of steps or units is not limited to the listed steps or units, but may further include steps or units that are not listed or steps or units that are inherently included in the process, the method, the system, the product or the apparatus.

Reference to "embodiments" herein means that particular features, structures, or characteristics described in an embodiment may be included in at least one embodiment of the present disclosure. The phrase at various sections in the specification does not necessarily refer to one same embodiment, nor separate or alternative embodiments that are mutually exclusive of other embodiments. Any ordinary skilled person in the art shall understand that, both explicitly and implicitly, the embodiments described herein may be combined with other embodiments.

The present disclosure will be described in detail by referring to drawings and embodiments.

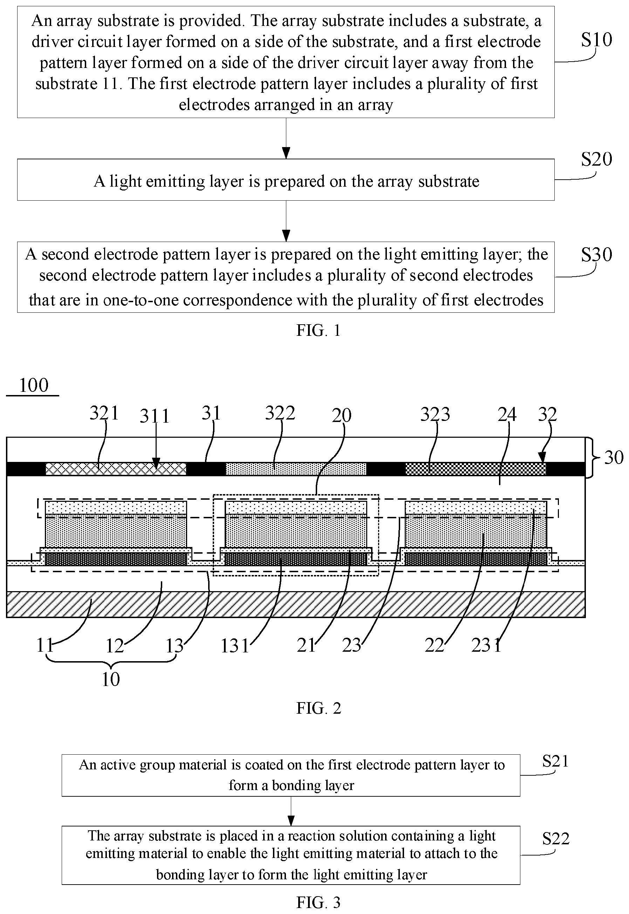

As shown in FIG. 1 and FIG. 2, FIG. 1 is a flow chart of a method of manufacturing a display panel according to a first embodiment of the present disclosure; and FIG. 2 is a structural schematic view of a display panel according to the first embodiment of the present disclosure. In the present embodiment, a method of manufacturing a display panel 100 is provided, the method is specifically performed to manufacture an OLED display panel 100, and the method includes the following.

In an operation S10, an array substrate 10 is provided. The array substrate 10 includes a substrate 11, a driver circuit layer 12 formed on a side of the substrate 11, and a first electrode pattern layer 13 formed on a side of the driver circuit layer 12 away from the substrate 11. The first electrode pattern layer 13 includes a plurality of first electrodes 131 arranged in an array.

In an operation S20, a light emitting layer 22 is prepared on the array substrate 10.

In an operation S30, a second electrode pattern layer 23 is prepared on the light emitting layer 22; the second electrode pattern layer 23 includes a plurality of second electrodes 231 that are in one-to-one correspondence with the plurality of first electrodes 131.

As shown in FIG. 2, the array substrate 10 provided at the operation S10 includes a substrate 11, the driver circuit layer 12, and the first electrode pattern layer 13. The driver circuit layer 12 is provided on a side of the substrate 11 and is configured to provide drive signals to light emitting units 20. Specifically, the driver circuit layer 12 includes a plurality of pixel driver circuits arranged in an array to provide the driver signals to a plurality of light emitting units 20 corresponding to the plurality of pixel driver circuits. The first electrode pattern layer 13 includes the plurality of first electrodes 131 arranged in the array, and the plurality of first electrodes 131 are in one-to-one correspondence with and electrically connected to the plurality of pixel driver circuits.

By performing the operation S20, the light emitting layer 22 is formed on the first electrode pattern layer 13. The light emitting layer 22 is formed on each of the plurality of first electrodes 131. By performing the operation S30, the second electrode pattern layer 23 is prepared on the light emitting layer 22, the second electrode pattern layer 23 includes the plurality of second electrodes 231. The plurality of second electrodes 231 are in one-to-one correspondence with the plurality of first electrodes 131, such that the light emitting layer 22 is disposed between the plurality of first electrodes 131 and the plurality of second electrodes 231. In this way, the plurality of light emitting units 20 are formed. The plurality of second electrodes 231 are electrically connected to the driver circuit layer 12, enabling the plurality of light emitting units 20 to receive the driver signals to emit light. Specifically, the plurality of first electrodes 131 and the plurality of second electrodes 231 are anodes and cathodes, respectively. In some embodiments, each of the plurality of first electrodes 131 is an anode; and each of the plurality of second electrodes 231 is a cathode; alternatively, each of the plurality of first electrodes 131 is the cathode; and each of the plurality of second electrodes 231 is the anode.

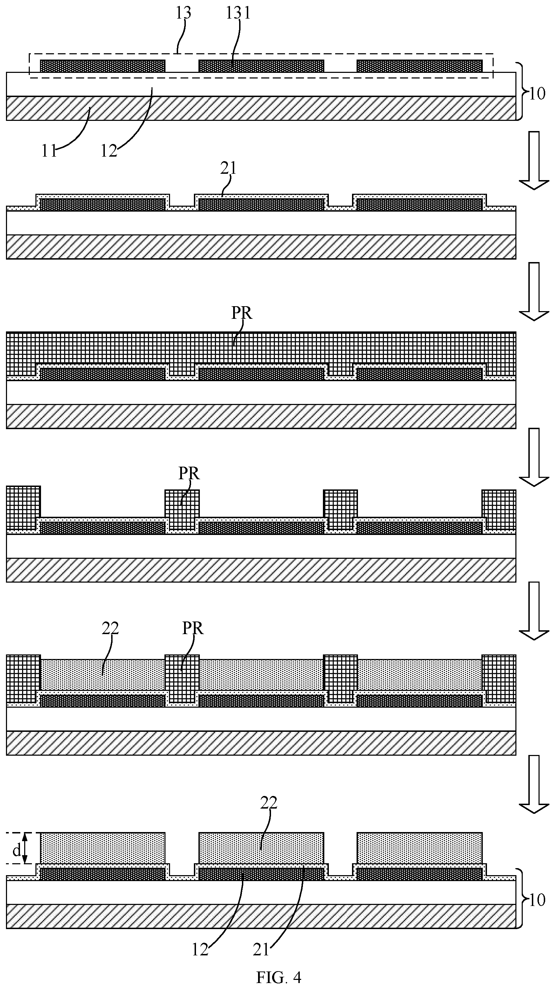

As shown in FIG. 3 and FIG. 4, FIG. 3 is a flow chart of a method of preparing the light emitting layer according to an embodiment of the present disclosure; and FIG. 4 is a process of the method of preparing the light emitting layer according to an embodiment of the present disclosure. Specifically, in the operation S20, a wet film-forming process is performed, to omit the FMM during manufacturing. The expensive equipment, such as the FMM and the vacuum evaporation deposition machine, are not needed, such that the manufacturing costs are reduced, and the competitiveness of the product is improved. The operation S20 includes the following:
In an operation S21, an active group material is coated on the first electrode pattern layer 13 to form a bonding layer 21.
In an operation S22, the array substrate 10 is placed in a reaction solution 40 containing a light emitting material to enable the light emitting material to attach to the bonding layer 21 to form the light emitting layer 22.

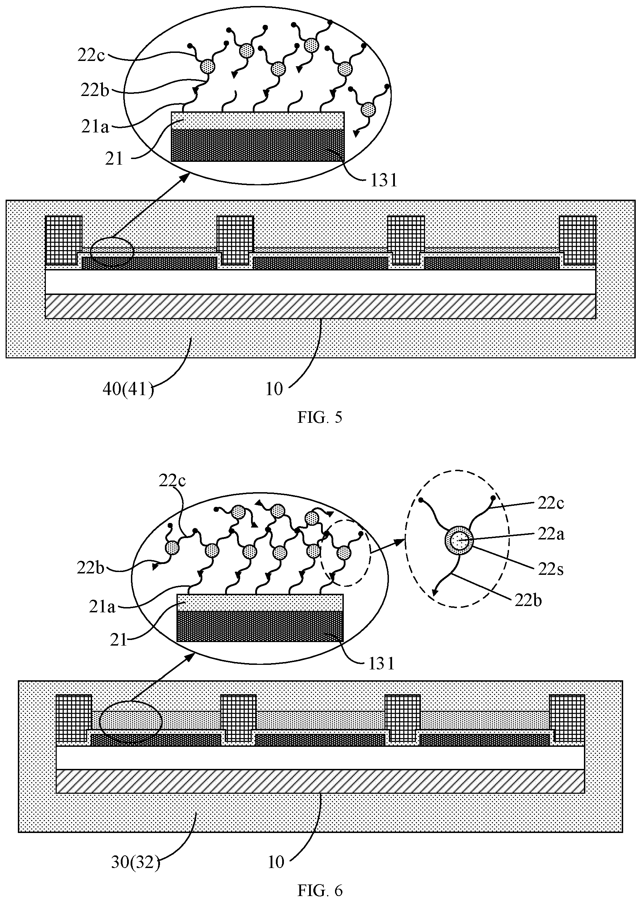

As shown in FIG.5 and FIG. 6, FIG. 5 is a structural schematic view of a first state of the array substrate being placed in the reaction solution according to the first embodiment of the present disclosure; and FIG. 6 is a structural schematic view of a second state of the array substrate being placed in the reaction solution according to the first embodiment of the present disclosure. Specifically, the active group material has a first functional group 21a, i.e., an active group material molecule has the first functional group 21a, and the active group material forms the bonding layer 21 on the first electrode pattern layer 13. The light emitting material has a second functional group 22b and a third functional group 22c, i.e., a light emitting material molecule has the second functional group 22b and the third functional group 22c. As shown in in FIG. 5, when the active group material and the light emitting material are placed under a specific chemical environment, the first functional group 21a and the second functional group 22b may undergo a grafting copolymerization reaction, enabling the active group material molecule and the light emitting material molecule to be combined to each other based on grafting between the first functional group 21a and the second functional group 22b. As shown in FIG. 6, when the light emitting material is in another specific chemical environment, the third functional group of one light emitting material molecule and the third functional group of another light emitting material molecule may undergo a polymerization reaction, such that the light emitting material molecules are combined with each other based on polymerization of the third functional groups 22c.

Specifically, the active group material may be a material having a 1,3,5-triazine structure. The light emitting material may include an organic light emitting material and/or an inorganic light emitting material. The organic light emitting material has the second functional group 22b and the third functional group 22c. For example, the organic material may be selectively grafted, based on chemical modification, with the second functional group 22b and the third functional group 22c. The second functional group 22b may be a hydroxyl group, an amino group, or other functional groups that can be grafting copolymerized with the first functional group 21a. The third functional group 22c may be a functional group which can be polymerized, such as a functional group of a double bond, an acid/alcohol carbonyl group, and so on. The third functional group 22c may be determined according to the actual needs, and the functional groups mentioned in the above are only exemplary and are not limited thereto. The inorganic light emitting material includes an inorganic inner core 22a and an organic shell layer 22s wrapping around the inorganic inner core 22a. The organic shell layer 22s is chemically modified to be grafting with a suitable second functional group 22b and a suitable third functional group 22c.

In the operation S22, the array substrate 10 is placed in the reaction solution 40 containing the light emitting material. The first functional group 21a of the active group material and the second functional group 22b of the light emitting material are firmly bonded to each other by the grafting copolymerization reaction. In this way, the light emitting material can be firmly attached to the bonding layer 21. Further, the third functional groups 22c of the light emitting material undergo the polymerization reaction to be bonded to each other, such that the light emitting material can be firmly bonded. In this way, the light emitting layer 22 having a preset thickness d is formed.

According to the above method, firstly, the light emitting material forms the film based on a wet chemical reaction method without using the FMM, the vacuum evaporation deposition machine, or other expensive equipment and materials. Therefore, the manufacturing costs are greatly reduced. Furthermore, the light emitting layer 22 is more stably bonded to the array substrate 10, and is less likely detached off from the array substrate. By performing wet film formation, a pixel defining layer PDL and pixel spacers PS are not prepared on the array substrate 10. A front part of a preparation process of the PDL and the PS can be eliminated, such that the manufacturing costs are further reduced, and a process time length is shortened. At the same time, according to the above wet film formation, a utilization rate of the light emitting material can be greatly improved, and a waste can be reduced and environmental pollution can be reduced. Further, after the reaction solution 40 containing the light emitting material decreases in concentration as reactions continues, only the light emitting material needs to be replenished in a timely manner, the entire reaction solution 40 does not need to be discarded, further reducing wastes and improving the utilization rate of the light emitting material. Moreover, as evaporation deposition is not required, a spacing between the plurality of first electrodes 131 only needs to satisfy a machine limit, a critical size deviation, and alignment accuracy. In this way, a pixel opening rate of the display panel 100 can be effectively improved, an area of the film formed from the light emitting material is increased. It can be understood that the spacing between light emitting layers 22 of different colors is no longer limited by limitation of a evaporation shadow area, and the spacing between adjacent first electrodes 131 can be narrowed, such that displaying resolution may be improved, and a displaying effect is improved.

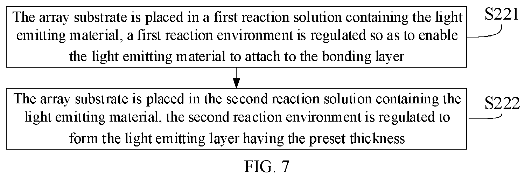

As shown in FIG. 7, FIG. 7 is a flow chart of the operation S22 according to an embodiment of the present disclosure. In the present embodiment, the operation S22 specifically includes the following.

In an operation S221, the array substrate 10 is placed in a first reaction solution 41 containing the light emitting material, a first reaction environment is regulated so as to enable the light emitting material to attach to the bonding layer 21.

In an operation S222, the array substrate 10 is placed in a second reaction solution 42 containing the light emitting material, a second reaction environment is regulated to enable the light emitting layer 22 having the preset thickness d to be formed.

In the present embodiment, the array substrate 10 is first placed in the first reaction solution 41 containing the light emitting material, and a concentration of the light emitting material in the first reaction solution 41 can be specifically determined according to production demands. The first reaction environment is regulated to enable the light emitting material have the grafting copolymerization reaction with the active group material. When a surface of the bonding layer 21 is uniformly covered with a layer of the light emitting material, the array substrate 10 is taken out of the first reaction solution 41. Subsequently, the array substrate 10 is placed in the second reaction solution 42 containing the light emitting material, and a concentration of the light emitting material in the second reaction solution 42 is determined according to production demands. The second reaction environment is regulated to enable the third functional groups 22c on the light emitting material to undergo the polymerization reaction. A reaction time length is controlled until a thickness of the film layer of the light emitting material on the bonding layer 21 reaches the preset thickness d. The array substrate 10 is then taken out of the second reaction solution 42, and a next process is performed. Specifically, the thickness of the light emitting layer 22 may be controlled by controlling the reaction time length, a reaction rate may be controlled by controlling reaction condition parameters.

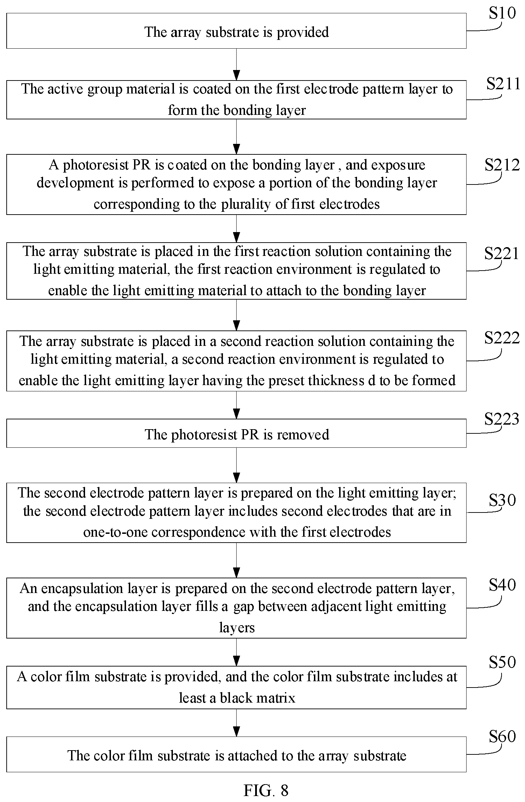

Specifically, as shown in FIG. 8, FIG. 8 is a flow chart of the method of manufacturing the display panel according to a second embodiment of the present disclosure. In the present embodiment, the method of manufacturing the display panel 100 specifically includes the following.

In an operation S10, the array substrate 10 is provided.

In an operation S211, the active group material is coated on the first electrode pattern layer 13 to form the bonding layer 21.

In an operation S212, a photoresist PR is coated on the bonding layer 21, and exposure development is performed to expose a portion of the bonding layer 21 corresponding to the plurality of first electrodes 131.

In an operation S221, the array substrate 10 is placed in the first reaction solution 41 containing the light emitting material, the first reaction environment is regulated to enable the light emitting material to attach to the bonding layer 21.

In an operation S222, the array substrate 10 is placed in the second reaction solution 42 containing the light emitting material, the second reaction environment is regulated to form the light emitting layer 22 having the preset thickness d

In an operation S223, the photoresist PR is removed.

In an operation S30, the second electrode pattern layer 23 is prepared on the light emitting layer 22; the second electrode pattern layer 23 includes the plurality of second electrodes 231 that are in one-to-one correspondence with the plurality of first electrodes 131.

In an operation S40, an encapsulation layer 24 is prepared on the second electrode pattern layer 23, and the encapsulation layer 24 fills a gap between adjacent light emitting layers 22.

In an operation S50, a color film substrate 30 is provided, and the color film substrate 30 includes at least a black matrix 31.

In an operation S60, the color film substrate 30 is attached to the array substrate 10.

Specifically, in the present embodiment, after the operation S211, the photoresist PR is firstly coated on the bonding layer 21 and is exposed and developed by a mask to expose the portion of the bonding layer 21 corresponding to the plurality of first electrodes 131. Further, the operations S221 and S222 are performed, in order to form the light emitting layer 22 of the preset thickness d on the bonding layer 21 at regions corresponding to the plurality of first electrodes 131. The photoresist PR is then removed, and the second electrode pattern layer 23 is prepared on the light emitting layer 22 to form the plurality of light emitting units 20 arranged in the array on the array substrate 10. In the present embodiment, the light emitting material may be a white light emitting material, and the light emitted from the formed light emitting units 20 is white. In the operation S40, the encapsulation layer 24 is formed on the plurality of light emitting units 20, and the encapsulation layer 24 fills the gap between adjacent light emitting units 20. In this way, the plurality of light emitting units 20 are encapsulated, preventing external water and oxygen from invading to affect the light emitting units 20, preventing a service life of the display panel 100 from being shortened. The color film substrate 30 is attached to the encapsulation layer 24 to form the display panel 100. The color film substrate 30 includes a black matrix 31 and a color film layer 32. The black matrix 31 has a plurality of pixel openings 311, the plurality of pixel openings 311 are arranged corresponding to the plurality of light emitting units 20. The color film layer 32 is received within the plurality of pixel openings 311. The color film layer 32 includes a first color resist layer 321, a second color resist layer 322, and a third color resist layer 323. In this way, a color display is achieved.

In the present embodiment, the light emitting layer 22 is formed by the wet film formation without evaporation, such that the manufacturing costs are reduced, and waste of the light emitting material is reduced, and the utilization rate of light emitting material is improved significantly. Furthermore, a front part process for preparing the PDL and the PS is eliminated, greatly reducing a process duration and manufacturing and material costs. The spacing between adjacent light emitting units 20 is no longer affected by the evaporation shadow area, such that the spacing is reduced, a pixel opening rate is improved, and a display resolution is improved.

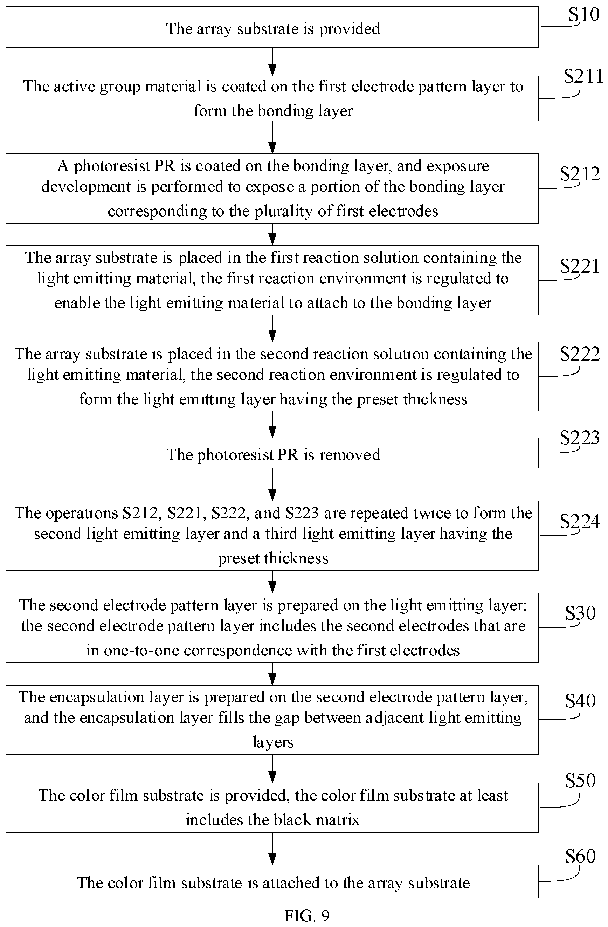

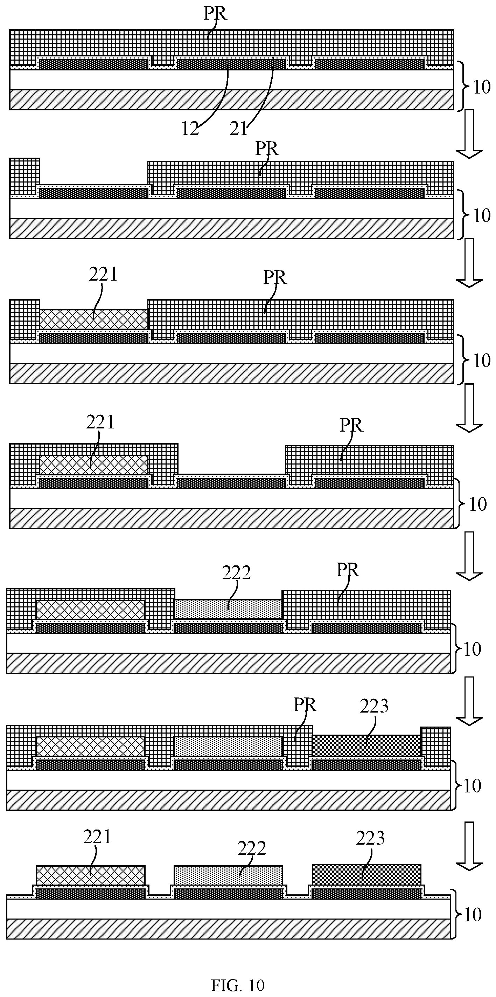

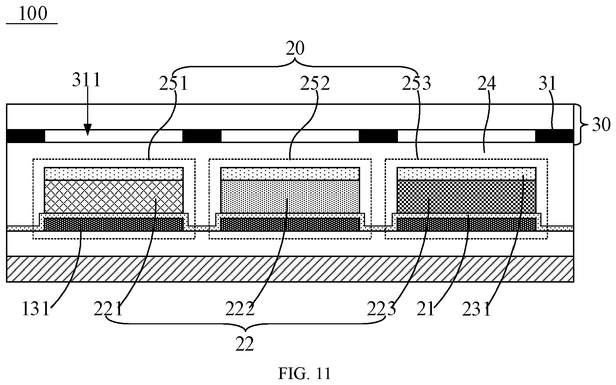

Specifically, as shown in FIGS. 9-11, FIG. 9 is a flow chart of the method of manufacturing the display panel according to a third embodiment of the present disclosure; FIG. 10 is a process of the method of preparing the light emitting layer shown in FIG. 9; and FIG. 11 is a structural schematic view of the display panel manufactured based on the method shown in FIG. 9. In the present embodiment, the method of manufacturing the display panel 100 specifically includes the following.

In an operation S10, the array substrate 10 is provided.

In an operation S211, the active group material is coated on the first electrode pattern layer 13 to form the bonding layer 21.

In an operation S212, the photoresist PR is coated on the bonding layer 21 and is exposed and developed to expose the portion of the bonding layer 21 corresponding to pixels.

In an operation S221, the array substrate 10 is placed in the first reaction solution 41 containing the light emitting material, the first reaction environment is regulated so as to enable the light emitting material to attach to the bonding layer 21.

In an operation S222, the array substrate 10 is placed in the second reaction solution 42 containing the light emitting material, the second reaction environment is regulated to form the first light emitting layer 221 having the preset thickness d.

In an operation S223, the photoresist PR is removed.

In an operation S224, the operations S212, S221, S222, and S223 are repeated twice to form the second light emitting layer 222 and a third light emitting layer 223 having the preset thickness d.

In an operation S30, the second electrode pattern layer 23 is prepared on the light emitting layer 22; the second electrode pattern layer 23 includes the plurality of second electrodes 231 that are in one-to-one correspondence with the plurality of first electrodes 131.

In an operation S40, the encapsulation layer 24 is prepared on the second electrode pattern layer 23, and the encapsulation layer 24 fills the gap between adjacent light emitting layers 22.

In an operation S50, the color film substrate 30 is provided, the color film substrate 30 at least includes the black matrix 31

In an operation S60, the color film substrate 30 is attached to the array substrate 10.

Being different from the second embodiment, in the present embodiment, the wet film formation is performed three times, so as to form the first light emitting layer 221, the second light emitting layer 222, and the third light emitting layer 223 of different colors on the driver substrate. Therefore, after the operation S30, a first light emitting unit 251, a second light emitting unit 252, and a third light emitting unit 253 having different colors are formed, such that color displaying of the display panel 100 is achieved. Therefore, in the present embodiment, the color film substrate 30 may include only the black matrix 31, and the color film layer 32 may be omitted. The black matrix 31 is configured to prevent color interference between adjacent light emitting units 20, such that the contrast of the display panel 100 is improved. Of course, in other embodiments, the black matrix 31 may not be arranged, which may be determined according to actual needs. Furthermore, in the process of preparing the first light emitting layer 221, the second light emitting layer 222, and the third light emitting layer 223, the operation 211 needs to be performed for only once, and an orthographic projection of the bonding layer 21 on the first electrode pattern layer 13 covers the first electrode pattern layer 13, so as to connect the light emitting material with the plurality of first electrodes 131.

It can be understood that in the process of forming the first light emitting layer 221, in the operation S212, the photoresist PR is exposed and developed by the mask, so as to expose the region of the bonding layer 21 in which the first light emitting unit 251 is arranged. In this way, after the operations S221 and S222, the first light emitting layer 221 is formed in the region in which the first light emitting unit 251 is arranged. The light emitting material in the reaction solution 41 and in the second reaction solution 42 is in a first color. In the process of forming the second light emitting layer 222, in the operation S212, the photoresist PR is exposed and developed by the mask to expose a region of the bonding layer 21 in which the second light emitting unit 252 is arranged. In this way, after the operations S221 and S222, the second light emitting layer 222 is formed in the region in which the second light emitting unit 252 is arranged. In the operations S221 and step S222, the light emitting material in the first reaction solution 41 and in the second reaction solution 42 is in a second color. In the process of forming the third light emitting layer 223, in the operation S212, the photoresist PR is exposed and developed by the mask to expose a region of the bonding layer 21 in which the third light emitting unit 253 is arranged. In this way, after the operations S221 and S222, the second light emitting layer 222 is formed in the region in which the third light emitting unit 253 is arranged. In the operations S221 and step S222, the light emitting material in the first reaction solution 41 and in the second reaction solution 42 is in a third color.

n the present embodiment, the display panel 100 is prepared from the wet film formation, without performing evaporation. In this way, the spacing between adjacent first electrodes 131 only needs to satisfy the machine limit, the critical size deviation, and the alignment accuracy. In this way, the spacing between adjacent first electrodes 131 is reduced, and an area of the plurality of first electrodes 131 is increased, such that an area of the light emitting layer 22 is increased, and the pixel opening rate is effectively improved. The spacing between different light emitting layers 22 is no longer affected by the evaporation process, such that the spacing between adjacent light emitting units 20 is reduced, the display resolution is significantly improved, and the displaying effect is improved.

To be noted that, according to the display pane, 1 100 and the method of manufacturing the display panel 100 provided in the above embodiment a structure of the display panel 100 can be modified. For example, a hole transport layer, an electron blocking layer, and other film layers may be arranged on the plurality of first electrodes 131. All the film layers can be formed by the above-described wet film formation. Furthermore, the active group material is configured to connect the light emitting material with an underlying material (the first electrodes 131) and may be configured as one layer or a plurality of layers, as long as connection between the light emitting material with the underlying material is achieved. The polymerization reaction of the light emitting material is to enable the light emitting layer 22 to reach the preset thickness d. The polymerization reaction or other types of chemical reactions of the light emitting material, such as electrostatic attraction, condensation reactions between functional groups of the light emitting material molecules and so on, may be applied, as long as the light emitting material can be polymerized and grown to the preset thickness d. In the above embodiment, an order of preparing the first light emitting layer 221, the second light emitting layer 222, and the third light emitting layer 223 may be adjustable, which can be determined according to the actual production requirements.

The above is only an implementation of the present disclosure, and is not intended to limit the scope of the present disclosure. Any equivalent structure or equivalent process transformation performed based on the contents of the specification and the accompanying drawings of the present disclosure, applied directly or indirectly in other related technical fields, shall be equivalently included in the scope of the present disclosure.

## Claims

1. A method of manufacturing a display panel, comprising:
providing an array substrate, wherein the array substrate comprises a substrate, a driver circuit layer formed on a side of the substrate, and a first electrode pattern layer formed on a side of the driver circuit layer away from the substrate; the first electrode pattern layer comprises a plurality of first electrodes arranged into an array;
preparing a light emitting layer on the array substrate;
preparing a second electrode pattern layer on the light emitting layer; wherein the second electrode pattern layer comprises a plurality of second electrodes in one-to-one correspondence with the plurality of first electrodes;
wherein the preparing a light emitting layer on the array substrate, comprises:
coating an active group material on the first electrode pattern layer to form a bonding layer;
placing the array substrate in a reaction solution containing a light emitting material to enable the light emitting material to attach to the bonding layer to form the light emitting layer;
wherein the active group material has a first functional group, the light emitting material has a second functional group and a third functional group; in a reaction stage, the second functional group and the first functional group undergo a grafting copolymerization reaction to enable the light emitting material to attach to the bonding layer; and third functional groups undergo a polymerization reaction to form the light emitting layer having a preset thickness.

2. The method according to claim 1, wherein the active group material is a chemical group material comprising a triazine structure; the second functional group is a hydroxyl group or an amino group; and the third functional group is a double bond or an acid/alcohol carbonyl group.

3. The method according to claim 1, wherein the placing the array substrate in a reaction solution containing a light emitting material to enable the light emitting material to attach to the bonding layer to form the light emitting layer, comprises:
placing the array substrate in a first reaction solution containing the light emitting material, regulating a first reaction environment, to enable the light emitting material to the bonding layer;
placing the array substrate in a second reaction solution containing light emitting material, regulating a second reaction environment, to form the light emitting layer having the preset thickness.

4. The method according to claim 3, wherein during the placing the array substrate in a second reaction solution containing light emitting material, regulating a second reaction environment, to form the light emitting layer having the preset thickness, the thickness of the light emitting layer is regulated by controlling a reaction time length, and a reaction rate is controlled by controlling parameters of reaction conditions.

5. The method according to claim 1, wherein,
prior to the placing the array substrate in a reaction solution containing a light emitting material, the method further comprises:
coating a photoresist on the bonding layer, performing exposure development to expose a portion of the bonding layer corresponding to the plurality of first electrodes; and
after the placing the array substrate in a reaction solution containing a light emitting material to enable the light emitting material to attach to the bonding layer to form the light emitting layer, the method further comprises:
removing a photoresist.

6. The method according to claim 1, wherein the light emitting layer comprises a first light emitting layer, a second light emitting layer, and a third light emitting layer; the method further comprises: repeating the operation of preparing the light emitting layer on the array substrate, so as to form the first light emitting layer, the second light emitting layer, and the third light emitting layer.

7. The method according to claim 6, wherein the first light emitting layer, a respective one of the plurality of first electrodes and a respective one of the plurality of second electrodes cooperatively form one first light emitting unit; the second light emitting layer, a respective one of the plurality of first electrodes and a respective one of the plurality of second electrodes cooperatively form one second light emitting unit; and the third light emitting layer, a respective one of the plurality of first electrodes and a respective one of the plurality of second electrodes cooperatively form one third light emitting unit;
during form the first light emitting layer, a photoresist is coated on the bonding layer, exposure and development is performed, so as to expose a region of the bonding layer in which the first light emitting unit is arranged;
during form the second light emitting layer, a photoresist is coated on the bonding layer, exposure and development is performed, so as to expose a region of the bonding layer in which the second light emitting unit is arranged;
during form the third light emitting layer, a photoresist is coated on the bonding layer, exposure and development is performed, so as to expose a region of the bonding layer in which the third light emitting unit is arranged.

8. The method according to claim 6, wherein during repeating the operation of preparing the light emitting layer on the array substrate, the coating the active group material on the first electrode pattern layer is performed only once; and an orthographic projection of the bonding layer on the first electrode pattern layer covers the first electrode pattern layer.

9. The method according to claim 6, wherein during repeating the operation of preparing the light emitting layer on the array substrate, so as to form the first light emitting layer, the second light emitting layer, and the third light emitting layer, a sequence of performing an operation of forming the first light emitting layer, an operation of forming the second light emitting layer, an operation of forming the third light emitting layer are adjustable.

10. The method according to claim 1, further comprising:
preparing an encapsulation layer on the second electrode pattern layer and filling the encapsulation layer in a gap between adjacent light emitting layers;
providing a color film substrate, wherein the color film substrate comprises at least a black matrix; and
attaching the color film substrate to the array substrate.

11. The method according to claim 1, wherein during forming the first electrode pattern layer, a spacing between two adjacent first electrodes of the plurality of first electrodes satisfies: a machine limit, a critical size deviation, and an alignment accuracy.

12. The method according to claim 1, wherein molecules of the light emitting material are electrostatic attracted to each other or undergo a condensation reaction between functional groups to form the light emitting layer having the preset thickness.

13. A display panel, comprising:
a driver substrate, comprising: a substrate, a driver circuit layer formed on a side of the substrate, and a first electrode pattern layer formed on a side of the driver circuit layer away from the substrate; the first electrode pattern layer comprises a plurality of first electrodes arranged into an array;
a light emitting layer, arranged on a side of the first electrode pattern layer away from the substrate;
a second electrode pattern layer, arranged on a side of the light emitting layer away from the first electrode pattern layer, wherein the second electrode pattern layer comprises a plurality of second electrodes in one-to-one correspondence with the plurality of first electrodes;
wherein the display panel further comprises a bonding layer, the bonding layer is disposed between the first electrode pattern layer and the light emitting layer; the bonding layer comprises an active group material, the active group material has a first functional group; the light emitting layer comprises a light emitting material, the light emitting material has a second functional group and a third functional group; the first functional group is grafted with the second functional group, to enable the light emitting layer to be attached to the bonding layer; third functional groups undergo a polymerization reaction to enable the light emitting material to form the light emitting layer having a preset thickness.

14. The display panel according to claim 13, wherein the light emitting material is an organic light emitting material and/or an inorganic light emitting material;
wherein the organic light emitting material has the second functional group and the third functional group; and
the inorganic light emitting material comprises an inorganic core and an organic shell layer wrapping around the inorganic core, the organic shell layer has the second functional group and the third functional group.

15. The display panel according to claim 13, wherein the display panel further comprises an encapsulation layer and a color film layer, the encapsulation layer is disposed on a side of the second electrode pattern layer away from the light emitting layer and fills a gap between adjacent light emitting layers, the color film layer is disposed on a side of the encapsulation layer away from the second electrode pattern layer.

16. The display panel according to claim 15, wherein the display panel further comprises a color film substrate attached to the encapsulation layer, the color film substrate comprises a black matrix and the color film layer, the black matrix has a plurality of pixel openings, the plurality of pixel openings correspond to a plurality of light emitting units; the color film layer is disposed within the plurality of pixel openings; the color film layer comprises a first color resist layer, a second color resist layer, and a third color resist layer; wherein the first color resist layer, the second color resist layer, and the third color resist layer are in different colors from each other.

17. The display panel according to claim 13, wherein the light emitting layer comprises a first light emitting layer, a second light emitting layer, and a third light emitting layer; wherein the first light emitting layer, the second light emitting layer, and the third light emitting layer are in different colors from each other; the first light emitting layer, the second light emitting layer, and the third light emitting layer being arranged in a preset sequence; the display panel further comprises an encapsulation layer, the encapsulation layer is disposed on a side of the second electrode pattern layer away from the light emitting layer and fills a gap between adjacent light emitting layers.

18. The display panel according to claim 17, wherein the display panel further comprises a color film substrate attached to the encapsulation layer, the color film substrate comprises only a black matrix, the black matrix has a plurality of pixel openings, the pixel openings are disposed corresponding to a plurality of light emitting units.
